# EUROPÄISCHE PATENTANMELDUNG

(11) **EP 3 300 252 A2**
(43) Veröffentlichungstag der Anmeldung: **28.03.2018**
(21) Anmeldenummer: 17178347.5
(22) Anmeldetag: 28.06.2017
(51) Int. Cl.: H03K 17/0814, H02H 7/22, H02H 9/04, H01H 9/54, H02M 1/34

(54) **STROMUNTERBRECHUNGSANORDNUNG, BATTERIESYSTEM, CONTROLLER UND VERFAHREN ZUM TRENNEN EINES STROMFLUSSES ZWISCHEN EINER BATTERIE UND EINEM VERBRAUCHER DER BATTERIE**

(30) Priorität: 30.08.2016 DE 102016216341
(71) Anmelder: Robert Bosch GmbH, 70442 Stuttgart (DE)
(72) Erfinder: Mothais, François, 70191 Stuttgart (DE); Galamb, Gergely, 83278 Traunstein (DE)

(57) **Zusammenfassung**

Die vorliegende Erfindung betrifft eine Stromunterbrechungsanordnung (1a; 1b; 1c) für ein Batteriesystem (100a; 100b; 100c), mit wenigstens einer Stromunterbrechungseinheit (10) zum Trennen eines elektrischen Stromflusses zwischen einer Batterie (70) des Batteriesystems (100a; 100b; 100c) und einem Verbraucher (200) der Batterie (70), wobei die Stromunterbrechungseinheit (10) wenigstens einen Leistungshalbleiter (11, 12) zum Trennen und Herstellen des Stromflusses zwischen der Batterie (70) und dem Verbraucher (200) der Batterie (70) aufweist und zu dem Leistungshalbleiter (11, 12) wenigstens ein Überspannungsableiter (30) parallel geschaltet ist. Die Erfindung betrifft ferner ein Batteriesystem (100a; 100b; 100c) mit einer erfindungsgemäßen Stromunterbrechungsanordnung (1a; 1b; 1c), ein Verfahren zum Trennen eines elektrischen Stromflusses zwischen einer Batterie (70) und einem Verbraucher (200) durch eine erfindungsgemäße Stromunterbrechungsanordnung (1a; 1b; 1c) sowie einen Controller (50) für ein erfindungsgemäßes Batteriesystem (100a; 100b; 100c), der zum Durchführen eines erfindungsgemäßen Verfahrens ausgestaltet ist.

## Beschreibung

Die vorliegende Erfindung betrifft eine Stromunterbrechungsanordnung, ein Batteriesystem, insbesondere ein Hochvolt-Batteriesystem eines Elektrofahrzeugs, einen Controller sowie ein Verfahren zum Trennen eines elektrischen Stromflusses zwischen einer Batterie und einem Verbraucher.

### Stand der Technik

Aus dem allgemeinen Stand der Technik ist es bekannt, dass zur Abschaltung von Überströmen bzw. Kurzschlussströmen in Batteriesystemen eine Kombination aus Schützen und Sicherungen eingesetzt wird. Bspw. wird an jedem Pol einer Batterie eines Batteriesystems ein Schütz verbaut, welches, getriggert durch einen Controller einer Überwachungselektronik, in einem Fehlerfall geöffnet wird. Treten in einem Kurzschlussfall zu hohe Ströme auf, die bspw. in einem Bereich von 2 kA bis 10 kA liegen, trennt eine mit den Schützen seriell geschaltete Sicherung nach 0,1 ms bis 2 s den Strom.

Aus der DE 10 2008 043 381 A1 ist eine Vorrichtung mit einer Hochvolt-Stromversorgungsbaugruppe sowie einem Controller für dieselbe bekannt. In der Hochvolt-Stromversorgungsbaugruppe ist eine Hochvolt-Batteriebaugruppe mit einer Leistungsschalterbaugruppe verbunden, welche elektromechanische oder elektronische Hochspannungs-Leistungsschalter (Relais) aufweist. Diese haben u. a. die Aufgabe, das Motorsteuergerät oder andere Hochspannungsverbraucher beim Einschalten der Fahrzeugelektronik elektrisch mit der Hochvoltbatterie zu verbinden bzw. bei einem Abschalten oder bei sicherheitskritischen Störungen sicher von der Hochvoltbatterie zu trennen.

### Offenbarung der Erfindung

Gemäß Anspruch 1 der vorliegenden Erfindung wird eine kostengünstige Stromunterbrechungsanordnung für ein Batteriesystem zur Verfügung gestellt, mit welcher auf sichere Weise kürzere Schaltzeiten, insbesondere beim Trennen eines elektrischen Stromflusses zwischen einer Batterie eines Batteriesystems und wenigstens einem Verbraucher der Batterie, realisierbar sind. Außerdem werden vorliegend ein Batteriesystem gemäß Anspruch 7 mit der Stromunterbrechungseinheit, ein Verfahren gemäß Anspruch 8 zum Trennen eines elektrischen Stromflusses zwischen der Batterie und dem Verbraucher der Batterie durch die Stromunterbrechungseinheit sowie ein Controller gemäß Anspruch 10, der zum Durchführen des Verfahrens mit der Stromunterbrechungseinheit ausgestaltet ist, bereitgestellt.

Weitere Merkmale der Erfindung ergeben sich aus der Beschreibung und den Zeichnungen. Dabei gelten Merkmale und Details, die im Zusammenhang mit der Stromunterbrechungsanordnung beschrieben sind, selbstverständlich auch im Zusammenhang mit dem erfindungsgemäßen Batteriesystem, dem erfindungsgemäßen Verfahren, dem erfindungsgemäßen Controller und jeweils umgekehrt, sodass bezüglich der Offenbarung zu den einzelnen Erfindungsaspekten stets wechselseitig Bezug genommen wird bzw. werden kann.

Gemäß eines ersten Aspekts der vorliegenden Erfindung wird eine Stromunterbrechungsanordnung für ein Batteriesystem zur Verfügung gestellt. Die Stromunterbrechungsanordnung weist wenigstens eine Stromunterbrechungseinheit zum Trennen eines elektrischen Stromflusses zwischen einer Batterie des Batteriesystems und einem Verbraucher der Batterie auf. Die Stromunterbrechungseinheit weist wenigstens einen Leistungshalbleiter zum Trennen und Herstellen des Stromflusses zwischen der Batterie und dem Verbraucher der Batterie auf. Außerdem ist zu dem Leistungshalbleiter wenigstens ein Überspannungsableiter parallel geschaltet.

Durch die erfindungsgemäße Parallelschaltung des Überspannungsableiters zu dem Leistungshalbleiter können transiente Überspannungen an dem Leistungshalbleiter zuverlässig und ohne Zerstörung oder Beschädigung des Leistungshalbleiters vorteilhaft abgebaut werden. Außerdem kann eine Überspannung durch den parallel geschalteten Überspannungsableiter besonders schnell abgebaut werden. Sobald eine Überspannung am Leistungshalbleiter auftritt, wird der parallel geschaltete Überspannungsableiter leitend und baut die dabei entstehende Energie thermisch ab. Der Überspannungsableiter ist bevorzugt derart ausgestaltet, dass dieser galvanisch isolierend wird, sobald ein Spannungsunterschied zwischen dem Überspannungsableiter und dem Leistungshalbleiter unter einen definierten Wert sinkt.

Der verwendete Leistungshalbleiter ist vorteilhaft für den Einsatz an einer Hochvolt-Batterie bzw. in einem Hochvolt-Batteriesystems mit einer Spannungsfestigkeit von bspw. 650 V ausgelegt. Die Batterie weist einschließlich eines Inverters eine Induktivität von 1 bis 50 µH auf.

Der erfindungsgemäße Überspannungsableiter kann außerdem anstelle eines möglichen weiteren Leistungshalbleiters parallel geschaltet sein. Im Vergleich zu einem weiteren Leistungshalbleiter kann durch den Überspannungsableiter ein deutlicher Kostenvorteil erzielt werden. Ein durchschnittlicher Überspannungsabieiter kostet ca. ein Zehntel eines durchschnittlichen Leistungshalbeiters. Als Überspannungsableiter kann bevorzugt eine Standardkomponente verwendet werden, die für den Überspannungsschutz ausgelegt ist. Hierdurch kann vorteilhaft, insbesondere im Vergleich zu einer Ausführungsform mit einem weiteren Leistungshalbleiter, eine besonders hohe Zuverlässigkeit beim Spannungsabbau erreicht werden, da Leistungshalbeiter nicht standardmäßig für einen hohen Energieabbau bei Überspannungsabschaltungen ausgelegt sind. Der Überspannungsableiter ist bevorzugt für Leistungsspitzen von mehr als 10 kW, besonders bevorzugt von mehr als 50 kW ausgelegt.

Die Stromunterbrechungsanordnung kann als elektrischer oder elektromechanischer Schalter ausgestaltet sein, der zum Trennen eines elektrischen Stromflusses zwischen der Batterie bzw. wenigstens einer Batterie und dem Verbraucher in einem Hauptstrompfad ausgestaltet und angeordnet ist. Unter dem Hauptstrompfad ist ein Strompfad zwischen der Batterie des Batteriesystems und dem Verbraucher der Batterie an einem positiven Terminal und einem negativen Terminal der wenigstens einen Batterie zu verstehen. Der Hauptstrompfad entspricht dabei einem Strompfad, in welchem üblicherweise die vorstehend zum Stand der Technik beschriebenen Schütze und die Schmelzsicherung angeordnet sind.

Die Batterie weist bevorzugt mehrere Batteriezellen auf, die in Reihe und/oder parallel geschaltet sein können. Dabei weist das Batteriesystem bevorzugt auch mehrere Batterien auf. Sowohl die Batteriezellen der Batterien als auch die Batterien selbst sind bevorzugt zumindest teilweise in Reihe geschaltet.

Unter dem Verbraucher ist vorliegend ein System zu verstehen, dass mit Strom und Spannung von der wenigstens einen Batterie versorgt wird bzw. versorgt werden kann. Der Verbraucher ist vorliegend bspw. ein Kraftfahrzeugnetz oder ein Elektromotor, der mit dem Kraftfahrzeugnetz verbunden ist.

Die vorliegende Stromunterbrechungsanordnung ist bevorzugt zur Verwendung in einem Kraftfahrzeug, insbesondere in einem Hochvolt-Batteriesystem eines Elektrofahrzeugs ausgestaltet. Die Erfindung ist dabei nicht auf die Verwendung in einem Straßenfahrzeug beschränkt. So ist es möglich, dass die Stromunterbrechungsanordnung auch entsprechend zur Verwendung in einem Schienenfahrzeug, in einem Wasserfahrzeug, in einem Luftfahrzeug und/oder in einem Roboter ausgestaltet ist. Darüber hinaus kann die Stromunterbrechungsanordnung auch entsprechend für die Verwendung in einem stationären System ausgestaltet sein.

Durch Verwendung des Leistungshalbleiters bzw. wenigstens eines Leistungshalbleiters kann vorteilhaft der Hauptstrompfad besonders schnell kurzgeschlossen werden. Unter einem Leistungshalbleiter ist ein Halbleiterbauelement zu verstehen, das bei der Verwendung in einer Leistungselektronik für das Steuern und Schalten hoher elektrischer Ströme und Spannungen ausgelegt ist, bspw. von mehr als 1 A bis zu mehreren 1000 A und Spannungen von mehr als 24 V. Als Leistungshalbleiter können bspw. Transistoren mit geeigneten Schalt- und Leistungseigenschaften verwendet werden.

Gemäß einer Weiterbildung der vorliegenden Erfindung ist es möglich, dass der wenigstens eine Leistungshalbleiter eine Spannungsfestigkeit aufweist, die größer als eine Durchbruchspannung des wenigstens einen Überspannungsabieiters ist. Wenn die Durchbruchspannung des Überspannungsableiters bspw. bei 600 V liegt, kann der Leistungshalbleiter vorteilhaft eine Spannungsfestigkeit von 650 V aufweisen. In diesem Fall wird bei Auftreten einer Überspannung die Energie ab 600 V am Überspannungsableiter abgebaut. Der Leistungshalbleiter kann dadurch entsprechend zuverlässig geschützt werden. In diesem Sinne hat es sich im Rahmen von Versuchen der vorliegenden Erfindung als vorteilhaft herausgestellt, wenn die Spannungsfestigkeit des Leistungshalbleiters zwischen 3% und 20%, bevorzugt zwischen 5% und 15% größer als die Durchbruchspannung des wenigstens einen Überspannungsableiters ist.

Ferner ist es bei einer erfindungsgemäßen Stromunterbrechungsanordnung möglich, dass zu dem wenigstens einen Überspannungsableiter ein Widerstand in Reihe geschaltet ist. Dadurch ist es vorteilhaft möglich, dass selbst bei einem Durchbruch des Überspannungsableiters innerhalb kürzester Zeit die aus der Überspannung resultierende Energie abgebaut werden kann und der Leistungshalbleiter nicht beschädigt oder zerstört wird. Der in Reihe geschaltete Widerstand dient somit als Sicherheit für einen Fehlerfall im Überspannungsableiter bzw. wenn der Überspannungsableiter nicht ausreichend dimensioniert ist.

Außerdem ist es gemäß der vorliegenden Erfindung möglich, dass bei einer Stromunterbrechungsanordnung der wenigstens eine Leistungshalbleiter als Bipolartransistor mit isolierter Gate-Elektrode (IGBT) ausgestaltet ist. Wenn der wenigstens eine Leistungshalbleiter als IGBT ausgestaltet ist, kann der Hauptstrompfad besonders schnell und zuverlässig kurzgeschlossen werden und mithin der Überstrom in Richtung der wenigstens einen Batterie entsprechend schnell und zuverlässig verhindert oder im Wesentlichen verhindert werden. Der IGBT weist ferner besonders hohe Spannungs- und Stromgrenzen auf. Dadurch kann ergänzend zu der durch den Überspannungsableiter geschaffenen Sicherheit eine zusätzliche Sicherheit für das Batteriesystem geschaffen werden. D.h., Spannung von bspw. 7 kV und Ströme von bspw. 4 kA, bei einer Leistung von bspw. 100 MW, kann der IGBT zerstörungsfrei steuern und schalten. Außerdem ist durch den IGBT eine leistungslose oder im Wesentlichen leistungslose Ansteuerung möglich. Darüber hinaus weist der IGBT eine besonders hohe Impulsbelastbarkeit auf.

Bei einer erfindungsgemäßen Stromunterbrechungsanordnung ist es zudem möglich, dass der wenigstens eine Leistungshalbleiter als Leistungs-Metall-Oxid-Halbleiter-Feldeffekttransistor (MOSFET) ausgestaltet ist. Wenn der wenigstens eine Leistungshalbleiter als Leistungs-MOSFET ausgestaltet ist, kann der Hauptstrompfad durch die schnelle Schaltzeit desselben besonders schnell und zuverlässig kurzgeschlossen werden und mithin ein Überstrom in Richtung der wenigstens einen Batterie entsprechend schnell und zuverlässig verhindert oder im Wesentlichen verhindert werden. Der Leistungs-MOSFET weist, ebenso wie der IGBT, besonders hohe Spannungs- und Stromgrenzen auf. Der Leistungs-MOSFET weist außerdem eine hohe Robustheit gegenüber Umwelteinflüssen auf. Dadurch ist der Leistungs-MOSFET insbesondere gut für die Verwendung in einem Kraftfahrzeug geeignet.

Außerdem ist es gemäß der vorliegenden Erfindung möglich, dass bei einer Stromunterbrechungsanordnung die Stromunterbrechungseinheit mehrere Leistungshalbleiter zum Trennen und Herstellen des Stromflusses zwischen der Batterie und dem Verbraucher aufweist und die mehreren Leistungshalbleiter in Reihe geschaltet sind. Durch die mehreren in Reihe geschalteten Leistungshalbleiter kann eine Wärme, die beim Trennen und Wiederherstellen von Strömen zwischen der Batterie und dem Verbraucher der Batterie entsteht, besser verteilt werden. D.h., dadurch kann der Gefahr einer Überhitzung eines einzelnen Leistungshalbleiters, wenn bspw. der Überspannungsableiter nicht ausreichend dimensioniert ist oder eine Fehlfunktion aufweist, Rechnung getragen werden.

Gemäß eines weiteren Aspekts der vorliegenden Erfindung wird ein Batteriesystem, insbesondere für ein Kraftfahrzeug, bevorzugt für ein Elektrofahrzeug, mit einer wie vorstehend im Detail beschriebenen Stromunterbrechungsanordnung zur Verfügung gestellt. Damit bringt das erfindungsgemäße Batteriesystem die gleichen Vorteile mit sich, wie sie ausführlich mit Bezug auf die erfindungsgemäße Stromunterbrechungsanordnung beschrieben worden sind. Die Stromunterbrechungsanordnung ist bevorzugt direkt oder in der Nähe einer positiven oder negativen Seite bzw. an einem entsprechenden Pol der Batterie angeordnet.

Gemäß eines weiteren Aspekts der vorliegenden Erfindung wird ein Verfahren zum Trennen eines elektrischen Stromflusses zwischen einer Batterie und einem Verbraucher durch eine wie vorstehend im Detail beschriebene Stromunterbrechungsanordnung bereitgestellt. Bei dem Trennen des Stromflusses wird eine hierbei entstehende thermische Energie zwischen dem wenigstens einen Leistungshalbleiter und dem wenigstens einen Überspannungsableiter zwischen dem wenigstens einen Leistungshalbleiter und dem wenigstens einen Überspannungsableiter aufgeteilt. Damit bringt auch das erfindungsgemäße Verfahren die gleichen Vorteile mit sich, wie sie ausführlich mit Bezug auf die erfindungsgemäße Stromunterbrechungsanordnung beschrieben worden sind.

Bei einer Weiterbildung des erfindungsgemäßen Verfahrens ist es von Vorteil, wenn der wenigstens eine Leistungshalbleiter zum Trennen des Stromflusses zumindest zeitweise vollständig sperrt und zumindest zeitweise in einem Active-Clamping-Modus betrieben wird. D.h., der Leistungshalbleiter kann derart konfiguriert werden, dass er einen Teil einer Abschaltzeit vollständig sperrt, wodurch der Überspannungsableiter leitet, und einen anderen Teil der Abschaltzeit in dem Active-Clamping-Modus betrieben wird. Dabei wird bevorzugt die Grenzspannung bzw. die Spannungsfestigkeit des Leistungshalbleiters kleiner als die Durchbruchspannung des Überspannungsableiters ausgewählt. Dadurch kann eine etwaige Überspannung im vorliegenden Batteriesystem besonders effizient abgebaut werden. Im Rahmen der vorliegenden Erfindung ist es auch denkbar, dass die Temperatur am Überspannungsableiter durch einen Temperatursensor überprüft wird und im Falle einer zu hohen Temperatur am Überspannungsableiter eine Fehlermeldung ausgegeben wird oder das Batteriesystem direkt abgeschaltet wird.

Außerdem wird gemäß eines Aspekts der vorliegenden Erfindung ein Controller für ein wie vorstehend beschriebenes Batteriesystem zur Verfügung gestellt, wobei der Controller zum Durchführen des vorstehend beschriebenen Verfahrens ausgestaltet ist. Zu diesem Zweck ist der Controller zumindest datentechnisch per Kabel und/oder Funk mit dem Batteriesystem und/oder der Stromunterbrechungsanordnung verbunden. Damit bringt auch der erfindungsgemäße Controller die gleichen Vorteile mit sich, wie sie ausführlich mit Bezug auf die erfindungsgemäße Stromunterbrechungsanordnung beschrieben worden sind.

Weitere, die Erfindung verbessernde Maßnahmen ergeben sich aus der nachfolgenden Beschreibung zu einigen Ausführungsbeispielen der Erfindung, welche in den Figuren schematisch dargestellt sind. Sämtliche aus den Ansprüchen, der Beschreibung oder der Zeichnung hervorgehende Merkmale und/oder Vorteile, einschließlich konstruktiver Einzelheiten und räumlicher Anordnungen können sowohl für sich als auch in den verschiedenen Kombinationen erfindungswesentlich sein.

Es zeigen jeweils schematisch:
- Fig. 1: ein Batteriesystem gemäß einer im Stand der Technik bekannten Ausführungsform,
- Fig. 2: ein Batteriesystem mit einer Stromunterbrechungsanordnung gemäß einer ersten Ausführungsform der vorliegenden Erfindung,
- Fig. 3: ein Batteriesystem mit einer Stromunterbrechungsanordnung gemäß einer zweiten Ausführungsform der vorliegenden Erfindung,
- Fig. 4: ein Batteriesystem mit einer Stromunterbrechungsanordnung gemäß einer dritten Ausführungsform der vorliegenden Erfindung, und
- Fig. 5: ein Diagramm zum Darstellen eines Stromverlaufs über die Zeit.

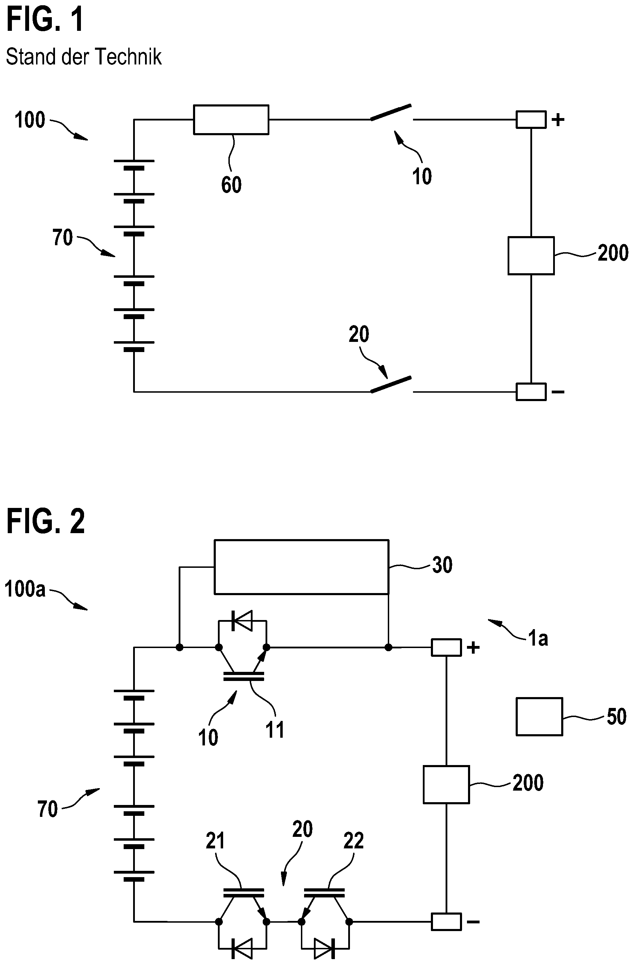

Elemente mit gleicher Funktion und Wirkungsweise sind in den Figuren 1 bis 5 jeweils mit demselben Bezugszeichen versehen.

In Fig. 1 ist ein im Stand der Technik bekanntes Batteriesystem 100 dargestellt. Das Batteriesystem 100 weist eine Batterie 70 und einen Verbraucher 200 der Batterie 70 auf. Ein Stromfluss zwischen der Batterie 70 und dem Verbraucher 200 kann durch ein erstes Schütz 10 und ein zweites Schütz 20 getrennt bzw. wiederhergestellt werden. Vor dem ersten Schütz 10, d.h., zwischen dem ersten Schütz 10 und einem positiven Pol der Batterie 70 ist in einem Hauptstrompfad eine Schmelzsicherung 60 angeordnet.

Fig. 2 zeigt ein Batteriesystem 100a mit einer Stromunterbrechungsanordnung 1a gemäß einer ersten Ausführungsform der vorliegenden Erfindung. Die in Fig. 2 dargestellte Stromunterbrechungsanordnung 1a weist eine erste Stromunterbrechungseinheit 10 und eine zweite Stromunterbrechungseinheit 20 auf. Die beiden Stromunterbrechungseinheiten 10, 20 sind zum Trennen eines elektrischen Stromflusses zwischen einer Batterie 70 des Batteriesystems 100a und einem Verbraucher 200 der Batterie 70 ausgestaltet. Die erste Stromunterbrechungseinheit 10 weist ferner einen als IGBT ausgestalteten ersten Leistungshalbleiter 11 auf. Die zweite Stromunterbrechungseinheit 20 weist einen als IGBT ausgestalteten dritten Leistungshalbleiter 21 und einen als IGBT ausgestalteten vierten Leistungshalbleiter 22 auf. Die Leistungshalbleiter 11, 21, 22 sind jeweils zum Trennen und Herstellen des Stromflusses zwischen der Batterie 70 und dem Verbraucher 200 der Batterie 70 ausgestaltet. Die Stromunterbrechungsanordnung 1a weist ferner einen Überspannungsableiter 30 auf, der zu dem ersten Leistungshalbleiter 11 parallel geschaltet ist. Der erste Leistungshalbleiter 11 weist dabei eine Spannungsfestigkeit auf, die größer als die Durchbruchspannung des Überspannungsableiters 30 ist. In Fig. 2 ist ferner ein Controller 50 dargestellt, der zum Steuern und/oder Regeln des Batteriesystems 100a konfiguriert ist.

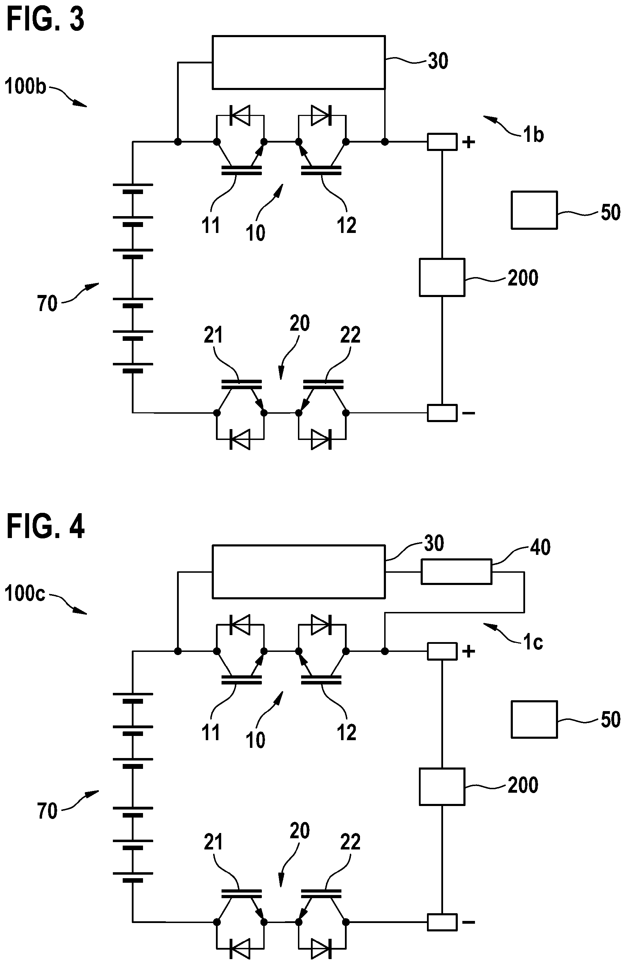

Fig. 3 zeigt ein Batteriesystem 100b mit einer Stromunterbrechungsanordnung 1b gemäß einer zweiten Ausführungsform der vorliegenden Erfindung. Die in Fig. 2 dargestellte Stromunterbrechungsanordnung 1b weist eine erste Stromunterbrechungseinheit 10 und eine zweite Stromunterbrechungseinheit 20 auf. Die beiden Stromunterbrechungseinheiten 10, 20 sind zum Trennen eines elektrischen Stromflusses zwischen einer Batterie 70 des Batteriesystems 100b und einem Verbraucher 200 der Batterie 70 ausgestaltet. Die erste Stromunterbrechungseinheit 10 weist ferner einen als IGBT ausgestalteten ersten Leistungshalbleiter 11 und einen als IGBT ausgestalteten zweiten Leistungshalbleiter 12 auf, der in Reihe zum ersten Leistungshalbleiter 11 geschaltet ist. Die zweite Stromunterbrechungseinheit 20 weist einen als IGBT ausgestalteten dritten Leistungshalbleiter 21 und einen als IGBT ausgestalteten vierten Leistungshalbleiter 22 auf. Die Leistungshalbleiter 11, 12, 21, 22 sind jeweils zum Trennen und Herstellen des Stromflusses zwischen der Batterie 70 und dem Verbraucher 200 der Batterie 70 ausgestaltet. Die Stromunterbrechungsanordnung 1b weist ferner einen Überspannungsableiter 30 auf, der zu dem ersten Leistungshalbleiter 11 und dem zweiten Leistungshalbleiter 12 parallel geschaltet ist. Der erste Leistungshalbleiter 11 sowie der zweite Leistungshalbleiter 12 weisen dabei jeweils eine Spannungsfestigkeit auf, die größer als die Durchbruchspannung des Überspannungsableiters 30 ist. In Fig. 3 ist ferner ein Controller 50 dargestellt, der zum Steuern und/oder Regeln des Batteriesystems 100b konfiguriert ist.

Fig. 4 zeigt ein Batteriesystem 100c mit einer Stromunterbrechungsanordnung 1c gemäß einer dritten Ausführungsform der vorliegenden Erfindung. Die in Fig. 4 dargestellte Stromunterbrechungsanordnung 1c weist eine erste Stromunterbrechungseinheit 10 und eine zweite Stromunterbrechungseinheit 20 auf. Die beiden Stromunterbrechungseinheiten 10, 20 sind zum Trennen eines elektrischen Stromflusses zwischen einer Batterie 70 des Batteriesystems 100c und einem Verbraucher 200 der Batterie 70 ausgestaltet. Die erste Stromunterbrechungseinheit 10 weist ferner einen als IGBT ausgestalteten ersten Leistungshalbleiter 11 und einen als IGBT ausgestalteten zweiten Leistungshalbleiter 12 auf, der in Reihe zum ersten Leistungshalbleiter 11 geschaltet ist. Die zweite Stromunterbrechungseinheit 20 weist einen als IGBT ausgestalteten dritten Leistungshalbleiter 21 und einen als IGBT ausgestalteten vierten Leistungshalbleiter 22 auf. Die Leistungshalbleiter 11, 12, 21, 22 sind jeweils zum Trennen und Herstellen des Stromflusses zwischen der Batterie 70 und dem Verbraucher 200 der Batterie 70 ausgestaltet. Die Stromunterbrechungsanordnung 1b weist ferner einen Überspannungsableiter 30 auf, der zu dem ersten Leistungshalbleiter 11 und dem zweiten Leistungshalbleiter 12 parallel geschaltet ist. Zu dem Überspannungsableiter 30 ist gemäß der in Fig. 4 dargestellten Ausführungsform außerdem ein Widerstand 40 in Reihe geschaltet. Der erste Leistungshalbleiter 11 sowie der zweite Leistungshalbleiter 12 weisen dabei jeweils eine Spannungsfestigkeit auf, die größer als die Durchbruchspannung des Überspannungsableiters 30 ist. In Fig. 4 ist ferner ein Controller 50 dargestellt, der zum Steuern und/oder Regeln des Batteriesystems 100c konfiguriert ist.

Bei einem erfindungsgemäßen Verfahren zum Trennen eines elektrischen Stromflusses zwischen einer Batterie 70 und einem Verbraucher 200 der Batterie mittels einer der dargestellten Stromunterbrechungsanordnungen 1a, 1b, 1c wird bei dem Trennen des Stromflusses eine hierbei entstehende thermische Energie zwischen dem wenigstens einen Leistungshalbleiter 11, 12 und dem Überspannungsableiter 30 zwischen dem wenigstens einen Leistungshalbleiter 11, 12 und dem wenigstens einen Überspannungsableiter 30 aufgeteilt. Zum Trennen des Stromflusses wird der wenigstens eine Leistungshalbleiter 11, 12 zeitweise vollständig gesperrt und zeitweise in einem Active-Clamping-Modus betrieben.

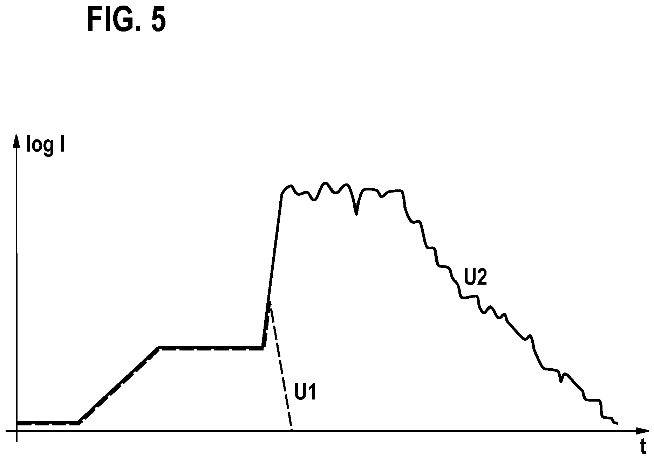

Fig. 5 zeigt ein Diagramm zum Darstellen eines Stromverlaufs bei der Durchführung des erfindungsgemäßen Verfahrens über die Zeit. Genauer gesagt zeigt Fig. 5 einen Überspannungsabbau U1 an einer erfindungsgemäßen Stromunterbrechungseinheit im Vergleich zu einem Überspannungsabbau U2 an einer im Stand der Technik üblichen Stromunterbrechungseinheit. Wie in Fig. 5 deutlich zu erkennen ist, kann eine Überspannung durch die erfindungsgemäße Stromunterbrechungseinheit deutlich schneller abgebaut werden, wodurch außerdem ein wesentlich geringerer Stromanstieg entsteht.

Der in den Figuren dargestellte Controller 50 ist zum Durchführen des Verfahrens ausgestaltet, der über Kabel und/oder drahtlos mit dem Batteriesystem 100 und/oder der Stromunterbrechungsanordnung 1a; 1b; 1c verbunden ist. Die Erfindung lässt neben den dargestellten Ausführungsformen weitere Gestaltungsgrundsätze zu. So können die in den Figuren dargestellten IGBTs auch durch Leistungs-MOSFETs, Siliziumcarbid-Halbleiter, Galliumnitrid-Halbleiter oder andere Leistungshalbleiter ersetzt werden.

## Patentansprüche

1. Stromunterbrechungsanordnung (1a; 1b; 1c) für ein Batteriesystem (100a; 100b; 100c), mit wenigstens einer Stromunterbrechungseinheit (10) zum Trennen eines elektrischen Stromflusses zwischen einer Batterie (70) des Batteriesystems (100a; 100b; 100c) und einem Verbraucher (200) der Batterie (70),
**dadurch gekennzeichnet,**
**dass** die Stromunterbrechungseinheit (10) wenigstens einen Leistungshalbleiter (11, 12) zum Trennen und Herstellen des Stromflusses zwischen der Batterie (70) und dem Verbraucher (200) der Batterie (70) aufweist und zu dem Leistungshalbleiter (11, 12) wenigstens ein Überspannungsableiter (30) parallel geschaltet ist.

2. Stromunterbrechungsanordnung (1 a; 1b; 1c) nach Anspruch 1,
**dadurch gekennzeichnet,**
**dass** der wenigstens eine Leistungshalbleiter (11, 12) eine Spannungsfestigkeit aufweist, die größer als eine Durchbruchspannung des wenigstens einen Überspannungsableiters (30) ist.

3. Stromunterbrechungsanordnung (1c) nach einem der voranstehenden Ansprüche,
**dadurch gekennzeichnet,**
**dass** zu dem wenigstens einen Überspannungsableiter (30) zumindest ein Widerstand (40) in Reihe geschaltet ist.

4. Stromunterbrechungsanordnung (1a; 1b; 1c) nach einem der voranstehenden Ansprüche,
**dadurch gekennzeichnet,**
**dass** der wenigstens eine Leistungshalbleiter (11, 12) als Bipolartransistor mit isolierter Gate-Elektrode (IGBT) ausgestaltet ist.

5. Stromunterbrechungsanordnung (1 a; 1b; 1c) nach einem der voranstehenden Ansprüche,
**dadurch gekennzeichnet,**
**dass** der wenigstens eine Leistungshalbleiter (11, 12) als Leistungs-MetallOxid-Halbleiter-Feldeffekttransistor (MOSFET) ausgestaltet ist.

6. Stromunterbrechungsanordnung (1b; 1c) nach einem der voranstehenden Ansprüche,
**dadurch gekennzeichnet,**
**dass** die Stromunterbrechungseinheit (10) mehrere Leistungshalbleiter (11, 12) zum Trennen und Herstellen des Stromflusses zwischen der Batterie (70) und dem Verbraucher (200) aufweist und die mehreren Leistungshalbleiter (11, 12) in Reihe geschaltet sind.

7. Batteriesystem (100a; 100b; 100c), insbesondere für ein Kraftfahrzeug, mit einer Stromunterbrechungsanordnung (1a; 1b; 1c) nach einem der voranstehenden Ansprüche.

8. Verfahren zum Trennen eines elektrischen Stromflusses zwischen einer Batterie (70) und einem Verbraucher (200) durch eine Stromunterbrechungsanordnung (1a; 1b; 1c) nach einem der Ansprüche 1 bis 6, wobei bei dem Trennen des Stromflusses eine hierbei entstehende thermische Energie zwischen dem wenigstens einen Leistungshalbleiter (11, 12) und dem wenigstens einen Überspannungsableiter (30) zwischen dem wenigstens einen Leistungshalbleiter (11, 12) und dem wenigstens einen Überspannungsableiter (30) aufgeteilt wird.

9. Verfahren nach Anspruch 8,
**dadurch gekennzeichnet,**
**dass** der wenigstens eine Leistungshalbleiter (11, 12) zum Trennen des Stromflusses zumindest zeitweise vollständig sperrt und zumindest zeitweise in einem Active-Clamping-Modus betrieben wird.

10. Controller (50) für ein Batteriesystem (100a; 100b; 100c) nach Anspruch 7, der zum Durchführen eines Verfahrens nach Anspruch 8 oder 9 ausgestaltet ist.
